# EUROPÄISCHE PATENTSCHRIFT

(11) **EP 0 633 475 B1**
(45) Veröffentlichungstag und Bekanntmachung des Hinweises auf die Patenterteilung: **24.09.2003**
(21) Anmeldenummer: 94110467.1
(22) Anmeldetag: 05.07.1994
(51) Int. Cl.: G01R 1/00, G01R 1/067, G01R 1/04, H01R 27/00, H01R 31/06

(54) **Anschluss für elektrische Geräte**
Interface for electric devices
Adaptateur pour appareils électriques

(30) Priorität: 06.07.1993 DE 4322407
(43) Veröffentlichungstag der Anmeldung: 11.01.1995
(73) Patentinhaber: GOSSEN-METRAWATT Gesellschaft mit beschränkter Haftung, D-90471 Nürnberg (DE)
(72) Erfinder: Herdt, Peter, D-90429 Nürnberg (DE); Hochreuther, Karl, D-90480 Nürnberg (DE)
(74) Vertreter: Hafner, Dieter, Dr.rer.nat., Dipl.-Phys.

(56) Entgegenhaltungen:
- EP-A- 0 128 472
- EP-A- 0 166 209
- EP-A- 0 317 475
- DE-A- 2 152 682
- US-A- 4 904 195

## Beschreibung

Die vorliegende Erfindung betrifft einen Prüf- oder Meßkopf für elektrische Prüfund/oder Meßgeräte mit den weiteren Merkmalen des Oberbegriffes des Patentanspruches 1.

Aus DE 36 00 934 ist ein Meßadapter zum Messen elektrischer Größen bekannt, der ein Gehäuse aufweist, in dem unterschiedliche Meßabnehmer angeordnet sind. Durch Handgriffe an dem Gehäuse können die Meßabnehmer aus der Spitze des Gehäuses nach Art eines Mehrfarben-Kugelschreibers ausgefahren und in Funktionsposition gebracht werden.

Aus US-PS 4,815,983 ist es ferner bekannt, einen Netzstecker durch einen Adaptereinsatz so zu modifizieren, daß er für unterschiedliche Steckersysteme in unterschiedliche Ländern einsetzbar ist.

Aus dem Datenblatt 902000 der Firma ROHDE und Schwarz geht ferner ein Steckersystem hervor, das für unterschiedliche Einsatzbereiche umrüstbar ist, wobei vorgesehen ist, daß ein Umrüsteinsatz an einem Stecker eines Gerätes (beispielsweise einer HF-Buchse) eingeschraubt und mit Gewindestiften festgelegt wird.

Aus DE-OS 36 25 675 ist es bekannt, einen insbesondere für Magnetspulen geeigneten elektrischen Stecker, umrüstbar zu gestalten. Dazu weist der Steckeinsatz an wenigstens zwei Außenflächen unterschiedliche Kontaktanordnungen und/oder Kontaktformen auf, die bei unterschiedlicher Einsteckweise in das Steckergehäuse jeweils die wirksame Kontaktfläche bilden. Auf diese Weise kann durch Herausziehen, Umdrehen und Wiedereinstecken des Steckeinsatzes eine schnelle Anpassung und eine geänderte Anschlußkonfiguration erfolgen.

Aus EP-A 0 166 209 ist ein Meßgerät zur Überprüfung der Schutzmaßnahmen in elektrischen Anlagen bekannt, welches einen entsprechend einen Schutzkontaktstecker gestalteten dreipoligen Meßstecker aufweist. Eine Meßautomatik sorgt in Abhängigkeit von der Stellung eines Meßgrößenumschalters und der sich beim Einstecken des Meßsteckers an der Steckdose ergebenden Polung dafür, welche der Pole des Meßsteckers als Meßkontakte wirken. Ferner ist ein Kontaktadapter vorgesehen, der auf den Meßstecker als Steckkopf aufsetzbar ist. Der Kontaktadapter weist zwei Meßspitzen auf, von denen eine fest und die andere über einem Meßkabel mit dem Stecktopf verbunden ist. Mit den beiden Meßspitzen kann damit eine Messung an freien Leitungen erfolgen, wobei zur Bedienung des Meßgerätes beide Hände erforderlich sind.

Aus US-A 4 904 195 geht ein Adapterteil hervor, mit welchem eine Steckdose in einen Stecker verwandelbar ist. Sowohl von der Oberseite als auch von der Unterseite des scheibenförmigen Adapterteils stehen Elektrodenstifte ab, so daß eine Seite des Adapterteils mit der Steckdose verbindbar ist und die andere Seite in eine konventionelle Steckdose gesteckt werden kann.

Der Erfindung liegt die Aufgabe zugrunde, einen Prüf- und Meßkopf für elektrische Prüf- oder Meßgeräte mit den Merkmalen des Anspruches 1 derart weiterzubilden, daß er bei relativ geringen Herstellungskosten eine Verbesserung der Einsatzmöglichkeiten mit sich führt und insbesondere auch mehrpolige Kontakkonfigurationen ermöglicht. Diese Aufgabe wird durch die kennzeichnenden Merkmale des Patentanspruches 1 gelöst, zweckmäßige Ausgestaltungen ergeben sich aus den Unteransprüchen.

Die Erfindung bietet die Möglichkeit, unter Verwendung eines standardisierten Grundteils in Verbindung mit speziell ausgebildeten Adapterteilen Fertigungskapazitäten wesentlich besser auszunutzen, wodurch die Herstellungskosten eines gattungsgemäßen Anschlusses erheblich reduziert werden können. Ferner kann der Anwender den Anschluß den Erfordernissen entsprechen einfach und schnell umrüsten und ist deshalb nicht mehr nur auf eine spezielle Anschlußart festgelegt.

Zur Durchführung einer einfachen und rasch durchzuführenden Montage bzw. Demontage ist eine Schnellverbindung zwischen Grund- und Adapterteil vorgesehen beispielsweise in Form einer Schraub-, oder Bajonettverbindung oder einer Kombination davon.

Die elektrische Kontaktierung erfolgt während der Verbindung über Kontaktstifte, die in dazugehörige, vorzugsweise buchsenartige Gegenkontakte, welche vorzugsweise als Lamellenkörbe ausgebildet sein können, eingreifen bzw. an diesen angreifen.

Gegenstände der Ansprüche 3 und 4 gewährleisten konstruktive und fertigungstechnische Vorteile und dadurch bedingte Kosteneinsparungen.

Der in Anspruch 5 beanspruchte Gewindering gewährleistet zum einen eine einfach zu handhabende, zum anderen sichere Verbindung der beiden Bauteile zueinander. Dadurch, daß die beiden Bauteile axial ohne Verdrehung zueinander zusammengesteckt werden, bietet das Merkmal des Gewinderings zudem eine Vereinfachung der technischen Merkmale der Steckverbindung zwischen Grund- und Adapterteil.

Für ein einfaches, gut handhabbares Zusammenfügen von Grund- sowie Adapterteil sind erfindungsgemäß weiterhin Führungsmittel vorgesehen. Zu diesem Zweck kann bei einer besonders einfachen konstruktiven Ausgestaltung eine Ausnehmung im Grundteil vorgesehen sein, die eine Führung für den Vorsprung des Gehäuses des Adapterteils darstellt.

Vorzugsweise kann insbesondere im Bereich des Grundteils in gut handhabbarer Weise eine Steuertaste für die Elektronik des Anschlusses vorgesehen sein. Es ist ferner sehr vorteilhaft, wenn an dem die Meßspitze tragenden Adapterteil ein Kabel befestigt ist, an dessen freien Ende ein weiterer Meßabnehmer angeordnet ist.

Nachstehend werden unterschiedliche Ausgestaltungen der Erfindung anhand von Zeichnungen näher erläutert. Es zeigen:
- Fig. 1: eine vereinfachte Schnittdarstellung des Grundteils des erfindungsgemäßen Anschlusses mit Gewindering (a) sowie eine Teilschnittdarstellung eines Lamellenkorbs (b);
- Fig. 2: eine Darstellung eines spezifischen Adapterteils in Seitenansicht und teilweiser Schnittdarstellung (a), in Seitenansicht (b), in Rückansicht (c) sowie Vorderansicht (d);
- Fig. 3: den erfindungsgemäßen Anschluß in zusammengesetzter Form in teilweiser Schnittdarstellung von der Seite betrachtet (a) sowie eine Teilschnittdarstellung eines Lamellenkorbs, der einen Kontaktstift des Adapterteils kontaktiert (b);
- Fig. 4: die Darstellung gemäß Fig. 3a in teilweiser Schnittdarstellung von oben betrachtet sowie
- Fig. 5: (a - d) unterschiedlich ausgebildete, den jeweiligen Anforderungen enstprechende Adapterteile zur Verbindung mit dem standardisierten Grundteil.

Wiederkehrende Merkmale sind der Übersichtlichkeit halber lediglich jeweils mit einem Bezugszeichen versehen.

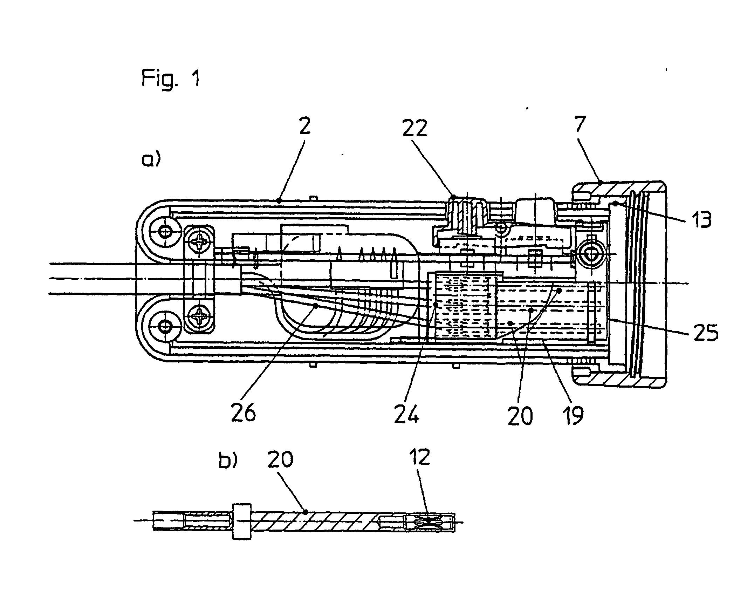

Fig. 1a zeigt das standardisierte Grundteil 2 des erfindungsgemäßen Anschlusses 1. Das Grundteil 2 besitzt eine längliche stabförmige Form mit einer stirnseitigen Öffnung 25 zur Aufnahme des jeweiligen, den speziellen Anforderungen angepaßten Adapterteils.

Im Bereich der stirnseitigen Öffnung ist drehbar zum Grundteil 2 ein daran unverlierbar gehaltener Gewindering 7 zur Herstellung einer Verbindung zum jeweiligen Adapterteil vorgesehen. Im Inneren des Grundteils 2 befinden sich mehrere, mit den einzelnen Hauptleitern 26 elektrisch verbundene Buchsen 20, die, wie sich aus Fig. 1b ergibt, jeweils einen sogenannten Lamellenkorb 12 beinhalten.

Jede Buchse 20 ist wiederum mit einem allen Buchsen 20 gemeinsamen Einsatzteil 24 fest verbunden, letzteres ist fest am Gehäuse des Grundteils 2 montiert. Die einzelnen, den jeweiligen Lamellenkorb 12 beinhaltende Buchsen 20 verlaufen parallel zur Längsachse des Grundteils 2 in Richtung zur Öffnung 25 desselben.

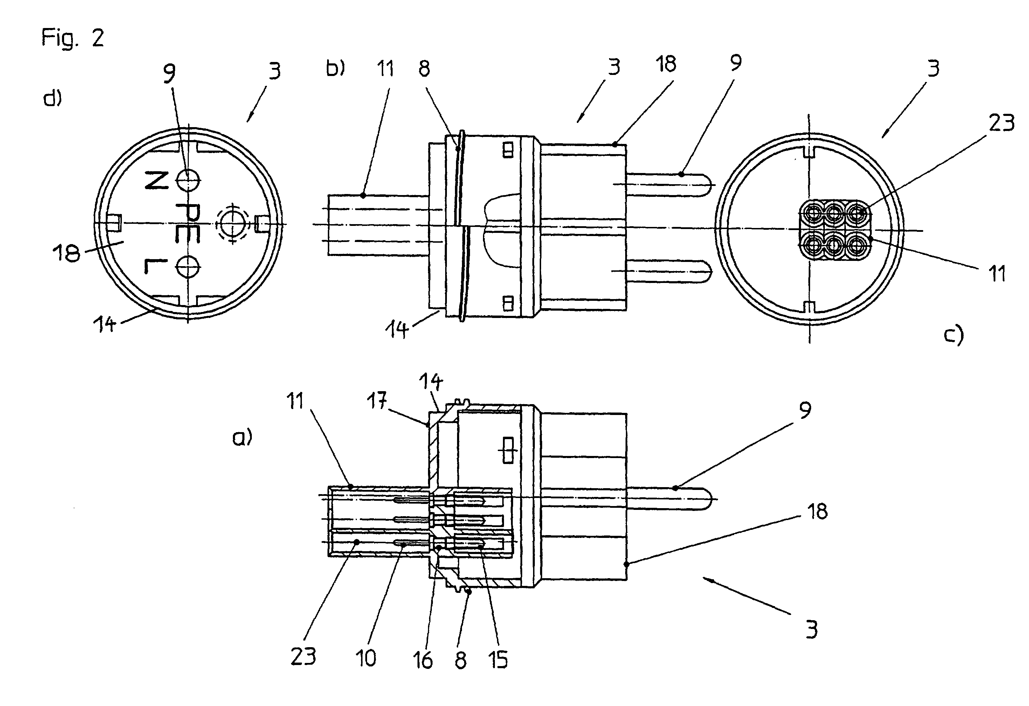

Die Buchsen 20 des Grundteils 2 sind innerhalb desselben von einer Wandung umgeben, die, betrachtet von der Öffnung 25 des Grundteils, eine Ausnehmung 19 bildet, in der die Buchsen 20 längsverlaufend angeordnet sind. Das Gehäuse des Grundteils 2 ist zweiteilig angebracht, wobei die beiden Teile miteinander verschraubt werden. Im Bereich der Öffnung 25 ist eine umlaufende Auskragung 13 vorgesehen, die zur Aufnehmung eines komplementär ausgebildeten Absatzes 14 (vgl. Fig. 2b z.B.) am jeweiligen Adapterteil dient.

Fig. 2 a) zeigt das Adapterteil 3 für den Einsatz in das Grundteil 2 gemäß Fig. 1., hier in Form eines Schukosteckers. Das Adapterteil 3 umfaßt ein standardisiertes Gehäuse 17 sowie einen in die offene Stirnseite des Gehäuses 17 einsetzbaren die jeweils länderunterschiedlich angepaßten Steckkontakte 9 enthaltenden Einsatz 18.

Zur Gewährleistung eines elektrischen Kontakts bei Zusammenfügen von Grundteil 2 und Adapterteil 3 sind mehrere Kontaktstifte 10 vorgesehen, die mit ihren Steckansätzen 15 in dem Gehäuse 17 des Adapterteils 3 verankert sind. Über an den Steckansätzen 15 angeschlagenen (nicht dargestellten) Drähten wird ein elektrischer Kontakt zu den Steckkontakten 9 hergestellt.

Die Kontaktstifte 10 sind von einem lediglich an der Vorderseite zum Teil offenen Vorsprung 11 umgeben, wobei jedem Kontaktstift 10 gemäß Fig. 2 c) ein entsprechender Kanal 23 zugeordnet ist. Der Vorsprung 11 und das Gehäuse 17 sind einstückig ausgebildet. An der Außenseite des Gehäuses 17 befindet sich ein Gewinde 8.

Je nach Einsatzbereich bzw. Einsatzgebiet kann der in den Fig. 2b sowie d) dargestellte Einsatz 18 den Anforderungen entsprechend unterschiedlich ausgestaltet sein.

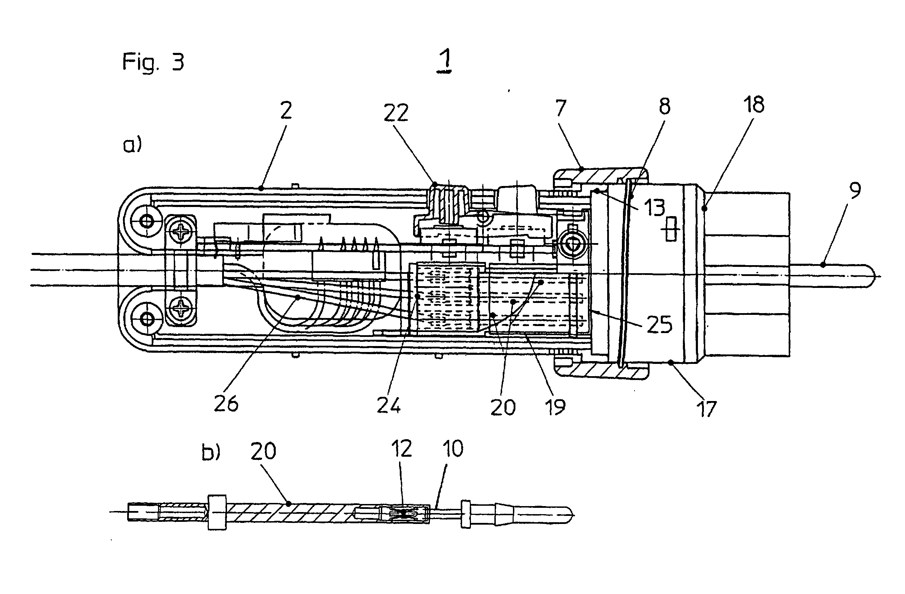

In zusammengebautem Zustand von Grundteil 2 und Adapterteil 3 taucht der Vorsprung 11 zusammen mit den einzelnen Kontaktstiften 10 in die an der Stirnseite des Grundteils 2 vorgesehene Ausnehmung 19 ein, wie die aus Fig. 3a ersichtlich ist. Die Ausnehmung 19 einerseits sowie die die einzelnen Buchsen 20 der Lamellenkörbe 12 aufnehmenden Kanäle 23 andererseits gewährleisten eine gute Führungsfunktion während des Zusammensteckens von Grundteil 2 und jeweiligem Adapterteil 3. Die Lamellenkörbe 12 (vgl. Fig. 3b) bieten hierbei eine gute Kontaktierung mit dem jeweiligen Kontaktstift 10.

Der Vorsprung 11 bewirkt zum einen einen Schutz vor Berührung eines Leiters bzw. Kontaktstifts 10 und vermeidet zum anderen Funkenschlag bei Spannungsspitzen.

Im Bereich des Grundteils 2 ist weiterhin eine Steuertaste 22 für die Elektronik des Anschlusses vorgesehen.

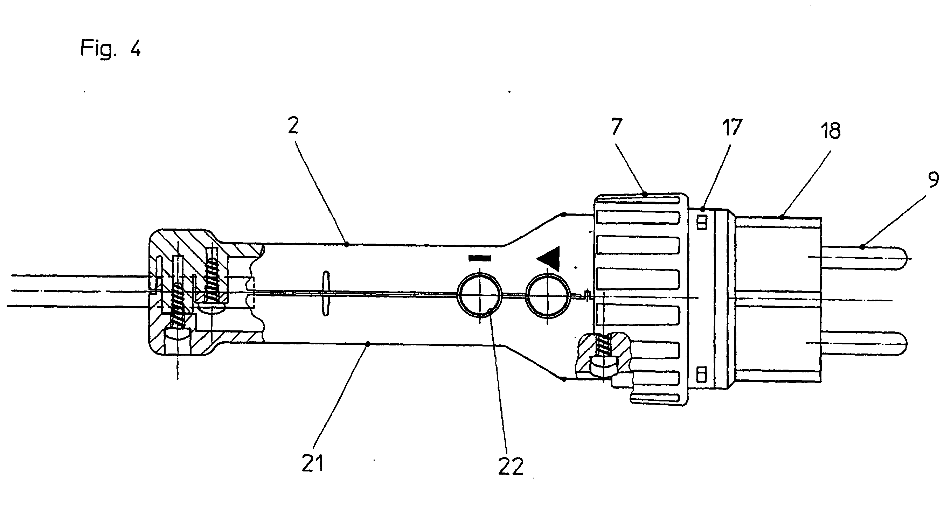

Wie sich aus Fig. 4 ergibt, befindet sich der Schalter an dem dem Adapterteil 3 zugewandten Ende einer im Grundteil 2 angeordneten Griffmulde 21.

Für den Zusammenbau des Anschlusses 1 ist es lediglich erforderlich, das jeweilige Adapterteil 3 in die stirnseitige Ausnehmung des Grundteils 2 einzustecken und den Gewindering 7 festzuziehen. Hierdurch ist eine einerseits schnell durchführbare gleichzeitig aber andererseits sichere Verbindung gewährleistet.

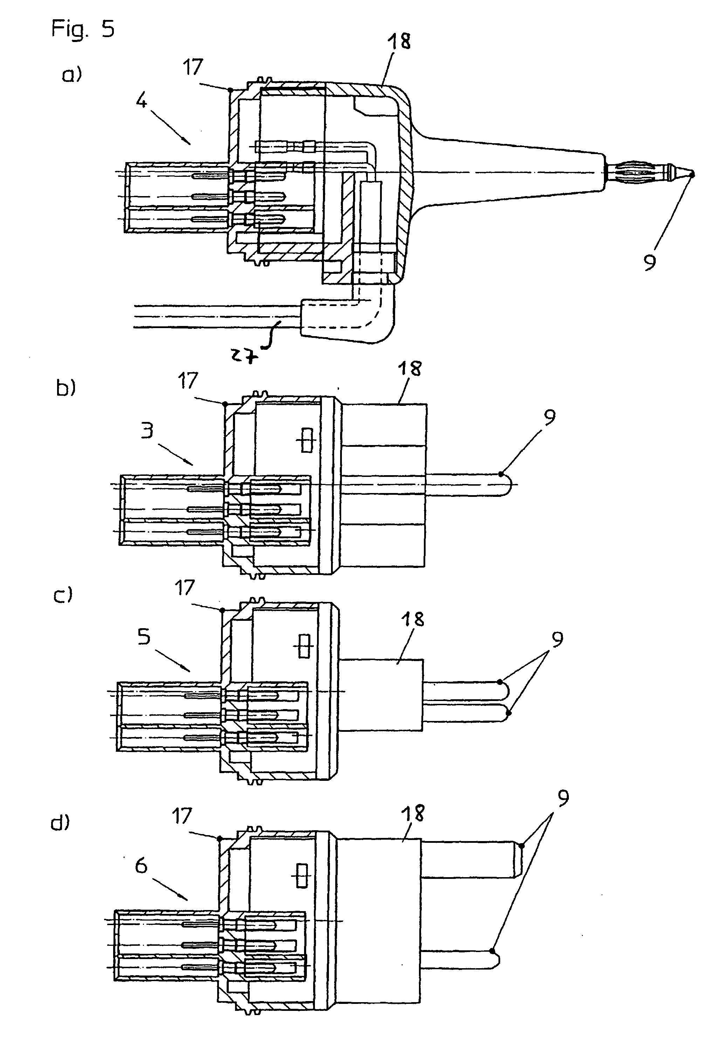

Aus den Fig. 5a - d sind den jeweiligen Einsatzbedingungen (länderspezifische Netzsysteme) angepaßte Adapterteile 3 - 6 dargestellt. Desweiteren zeigt die Darstellung in Fig. 5a ein Adapterteil 4 mit einer Prüfspitze als Steckkontakt 9. Die einzelnen in Fig. 5 dargestellten, unterschiedlichen Adapterteile besitzen jeweils ein einheitliches, standardisiertes Gehäuse 17, in dessen offene Stirnseite der jeweilige, länder- bzw. zweckspezifische Einsatz 18 untergebracht ist.

Das Adapterteil 4 mit der Prüfspitze ist ferner mit einem seitlich herausgeführten Kabel (27) versehen, an dessen Freiende ein weiterer Meßabnehmer angeordnet ist.

Die Erfindung bewirkt eine erhebliche Einsparung an Fertigungskosten einerseits sowie wesentlich verbesserte Einsatzmöglichkeiten derartiger gattungsgemäßer Anschlüsse andererseits. Sie stellt daher einen ganz besonderen Beitrag auf dem einschlägigen technischen Gebiet dar.

### BEZUGSZEICHENLISTE

- 1: Anschluß
- 2: Grundteil
- 3: Adapterteil
- 4: Adapterteil
- 5: Adapterteil
- 6: Adapterteil
- 7: Gewindering
- 8: Gewinde
- 9: Steckkontakt
- 10: Kontaktstift
- 11: Vorsprung des Gehäuses
- 12: Lamellenkorb
- 13: Auskragung
- 14: Absatz
- 15: Steckansatz
- 16: Bohrung
- 17: Gehäuse des Adapterteils
- 18: Einsatz
- 19: Ausnehmung im Grundteil 2
- 20: Buchse
- 21: Griffmulde
- 22: Steuertaste
- 23: Kanal
- 24: Einsatzteil
- 25: Öffnung
- 26: Hauptleiter
- 27: Kabel

## Patentansprüche

1. Prüf- oder Meßkopf für elektrische Prüf- und/oder Meßgeräte, mit einem Gehäuse, mindestens einem Kontaktstift (10) sowie Leitern zur Stromführung, wobei das Gehäuse ein griffartiges Grundteil (2) aufweist, welches mit für den jeweiligen Einsatzzweck speziell ausgebildeten unterschiedlichen Anschlußelementen zur Herstellung eines elektrischen Kontaktes versehen ist,
**dadurch gekennzeichnet, daß**
- der Prüf- oder Meßkopf austauschbare Adapterteile (3 - 6) umfaßt,
- die unterschiedlichen Anschlußelemente an den gesonderten Adapterteilen (3 - 6) angeordnet sind,
- welche mit einer Stirnseite des Grundteils (2) über eine zugfest fixierbare Schnellverbindung verbindbar sind und
- dazu an jedem aus austauschbaren Adapterteilen (3-6) bestehenden Adapter eine Anzahl und Anordnung von Kontaktstiften (10) angeordnet ist, die in Montagestellung zugehörige Gegenkontakte in Form von Buchsen (20) am Grundteil (2) kontaktieren, die in der Stirnseite des Grundteils (2) angeordnet sind,
- neben einem mit einer Prüfspitze versehenen Adapter mindestens ein weiterer Adapter mit Anschlußelementen in Form von Netzsteckern unterschiedlicher Kontaktkonfiguration mit der Stirnseite des Grundteils (2) verbindbar ist, wobei
- die Kontaktstifte (10) von einem Vorsprung (11) des Gehäuses (17) umgeben sind, der zumindest zum Teil an der Frontseite offen ist, der Vorsprung (11) im zusammengesetzten Zustand des Anschlusses in das Grundteil (2) eintaucht und hierbei die Buchsen (20) in die Frontseite des Vorsprungs (11) im Bereich der offenen Stellen eingreifen und
- das Gehäuse (17) des Adapterteils (3) einschließlich des Vorsprungs (11) und der Kontaktstiftanordnung unabhängig von der jeweiligen speziellen Art des Adapterteils (z. B. 3) standardisiert ausgebildet ist und lediglich ein an der Stirnseite des Gehäuses (17) vorgesehener Einsatz (18) den jeweiligen Anforderungen entsprechend geformt ist.

2. Prüf- oder Meßkopf nach Anspruch 1,
**dadurch gekennzeichnet, daß**
die Buchsen (20) als sog. Lamellenkörbe (12) ausgebildet sind, die die jeweiligen Kontaktstifte (19) zur Kontaktierung aufnehmen.

3. Prüf- oder Meßkopf nach Anspruch 1,
**dadurch gekennzeichnet, daß**
der Vorsprung, (11) mit dem Gehäuse (17) des Adapterteils (3) einstückig ausgebildet ist.

4. Prüf- oder Meßkopf nach einem der vorhergehenden Ansprüche,
**dadurch gekennzeichnet, daß**
der jeweilige Kontaktstift (10) einen Steckansatz (15) aufweist, über welchen dieser mit dem Gehäuse (17) des Adapterteils (3) verankert ist, wobei der Steckansatz (15) über einen elektrische Leiter, vorzugsweise Draht, mit dem Steckkontakt (9) verbunden ist.

5. Prüf- oder Meßkopf nach einem der vorhergehenden Ansprüche,
**dadurch gekennzeichnet, daß**
die Verbindung zwischen Grundteil (2) und dem jeweiligen Adapterteil (z. B. 3) über einen Gewindering (7) erfolgt, welcher entweder am Grundteil (2) oder am Adapterteil (3), vorzugsweise unverlierbar, drehbar zu diesem angeordnet ist und eine Schraubverbindung mit einem am gegenüberliegenden Teil vorgesehenen Gewinde (8) gewährleistet.

6. Prüf- oder Meßkopf nach einem der vorhergehenden Ansprüche,
**dadurch gekennzeichnet, daß**
Führungsmittel zur Erleichterung der Verbindung von Grundteil (2) sowie Adapterteil (3) vorgesehen sind.

7. Prüf- oder Meßkopf nach einem der vorhergehenden Ansprüche,
**dadurch gekennzeichnet, daß**
das Grundteil (2) eine Griffmulde (21) aufweist.

8. Prüf- oder Meßkopf nach einem der vorhergehenden Ansprüche,
**dadurch gekennzeichnet, daß**
im Bereich des Grundteils (2) eine Steuertaste (22) für eine elektronische Schaltung vorgesehen ist.

9. Prüf- oder Meßkopf nach einem der vorhergehenden Ansprüche,
**dadurch gekennzeichnet, daß**
an einem eine Meßspitze tragenden Adapterteil (4) seitlich ein Kabel (27) herausgeführt ist, das im Innenbereich des Adapterteils mit Anschlußelementen in Verbindung steht und an seinem freien Ende einen weiteren Meßabnehmer trägt.

## Claims

1. Probe or measuring head for electrical test sets and/or meters, having a casing, at least one contact pin (10) and conductors for carrying current, the casing having a handle-type base section (2), which is provided with various interfacing elements which are designed specifically for the respective application in order to make an electrical contact,
**characterised in that**
- the probe or measuring head comprises interchangeable adapter elements (3 - 6),
- the various interfacing elements are arranged on the separate adapter elements (3 - 6),
- which are connectable to one end face of the base section (2) via a quick-disconnect connector which is locatable in such a way as to provide resistance to tensile stress, and
- to that end, disposed on each adapter made up of interchangeable adapter elements (3 - 6) are a number and arrangement of contact pins (10) which when installed make contact with operatively associated mating contacts in the form of sockets (20) on the base section (2) which are arranged in the end face of the base section (2),
- in addition to an adapter equipped with a test prod, at least one other adapter with interfacing elements in the form of power plugs with various contact configurations is connectable to the end face of the base section (2), and
- the contact pins (10) are surrounded by a projecting area (11) of the casing (17) which is at least partly open on the front face, the projecting area (11) is covered by the base section (2) when the interface is in the assembled state, and at the same time the sockets (20) engage in the front face of the projecting area (11), in the vicinity of the open locations, and
- the casing (17) of the adapter element (3), inclusive of the projecting area (11) and the contact pin arrangement, has a standardised design irrespective of the particular special type of adapter element (e.g. 3), and just one insert (8) provided on the end face of the casing (17) is shaped in accordance with the respective requirements.

2. Probe or measuring head according to claim 1, **characterised in that** the sockets (20) are in the form of so-called lamellar baskets (12) which receive the respective contact pins (19) to make the contact.

3. Probe or measuring head according to claim 1, **characterised in that** the projecting area (11) is constructed in one piece with the casing (17) of the adapter element (3).

4. Probe or measuring head according to any of the preceding claims, **characterised in that** the respective contact pin (10) incorporates a push-fit neck (15) via which the latter is anchored to the casing (17) of the adapter element (3), the push-fit neck (15) being connected to the push-fit contact (9) via an electrical conductor, preferably a wire.

5. Probe or measuring head according to any of the preceding claims, **characterised in that** the connection between the base section (2) and the respective adapter element (e.g. 3) is via a threaded ring (7) which is arranged either on the base section (2) or on the adapter element (3), preferably in such a way that it cannot be lost, and so as to be able to turn in relation thereto, and ensures a screwed connection with a thread (8) provided on the opposite part.

6. Probe or measuring head according to any of the preceding claims, **characterised in that** guidance means are provided to facilitate the connection of the base section (2) and the adapter element (3).

7. Probe or measuring head according to any of the preceding claims, **characterised in that** the base section (2) incorporates a handle trough (21).

8. Probe or measuring head according to any of the preceding claims,
**characterised in that** a control key (22) for an electronic circuit is provided in the vicinity of the base section (2).

9. Probe or measuring head according to any of the preceding claims, **characterised in that** emerging sideways from an adapter element (4) which carries a measuring prod is a cable (27) which communicates with interfacing elements in the inner region of the adapter element and carries an additional pick-up on its free end.

## Revendications

1. Tête de contrôle ou de mesure pour appareils électriques de contrôle et/ou de mesure comportant un boîtier, au moins une broche de contact (10) ainsi que des conducteurs pour le passage du courant, le boîtier présentant une pièce de base (2) en forme de manche, laquelle est équipée de différents éléments de raccordement, spécialement conçus pour les différentes applications, pour l'établissement d'un contact électrique,
**caractérisée par le fait que**
- la tête de contrôle ou de mesure comprend des pièces d'adaptation (3 - 6) interchangeables,
- les différents éléments de raccordement sont disposés sur les pièces d'adaptation (3 - 6) séparées,
- lesquelles peuvent être connectées à une partie frontale de la pièce de base (2) par un raccord rapide à fixation résistante à la traction,
- chaque adaptateur constitué de pièces d'adaptation (3 - 6) interchangeables est muni pour cela d'un nombre et d'une disposition de broches de contact (10) qui, en position de montage, établissent un contact avec des contacts homologues sous la forme de douilles (20) de la pièce de base (2), situées dans la partie frontale de la pièce de base (2),
- il est possible de connecter à la partie frontale de la pièce de base (2), outre un adaptateur muni d'une pointe de touche, au moins un autre adaptateur avec des éléments de raccordement sous la forme de fiches secteur présentant différentes configurations de contacts, où
- les broches de contact (10) sont entourées par une saillie (11) du boîtier (17), laquelle est ouverte, au moins en partie, sur sa partie frontale, la saillie (11) s'enfonce dans la pièce de base (2) quand le raccord est assemblé, les douilles (20) s'engageant alors dans la partie frontale de la saillie (11) au niveau des ouvertures et
- le boîtier (17) de la pièce d'adaptation (3), y compris la saillie (11) et la disposition des broches de contact, est standardisé indépendamment de la nature particulière de la pièce d'adaptation considérée (p. ex. 3) et seul un insert (18) prévu sur la partie frontale du boîtier (17) est formé en fonction des besoins particuliers.

2. Tête de contrôle ou de mesure selon la revendication 1,
**caractérisée par le fait que**
les douilles (20) sont formées de contacts dits contacts à lamelles (12) qui reçoivent les broches de contact (19) correspondantes pour établir le contact.

3. Tête de contrôle ou de mesure selon la revendication 1,
**caractérisée par le fait que**
la saillie (11) forme une seule pièce avec le boîtier (17) de la pièce d'adaptation (3).

4. Tête de contrôle ou de mesure selon l'une des revendications précédentes,
**caractérisée par le fait que**
chaque broche de contact (10) présente un embout d'enfichage (15) au moyen duquel celle-ci est ancrée dans le boîtier (17) de la pièce d'adaptation (3), l'embout d'enfichage (15) étant relié au contact à fiche (9) par un conducteur électrique, de préférence un fil métallique.

5. Tête de contrôle ou de mesure selon l'une des revendications précédentes,
**caractérisée par le fait que**
la liaison entre la pièce de base (2) et la pièce d'adaptation considérée (p. ex. 3) est réalisée par une bague filetée (7) qui peut tourner sur la pièce de base (2) ou sur la pièce d'adaptation (3), de préférence d'une manière imperdable, et garantit un raccord vissé avec un filetage (8) prévu sur la pièce opposée.

6. Tête de contrôle ou de mesure selon l'une des revendications précédentes,
**caractérisée par le fait qu'**
il est prévu des moyens de guidage pour faciliter le raccordement de la pièce de base (2) et de la pièce d'adaptation (3).

7. Tête de contrôle ou de mesure selon l'une des revendications précédentes,
**caractérisée par le fait que**
la pièce de base (2) présente un évidemment de préhension (21).

8. Tête de contrôle ou de mesure selon l'une des revendications précédentes,
**caractérisée par le fait qu'**
il est prévu au niveau de la pièce de base (2) une touche de commande (22) pour un circuit électronique.

9. Tête de contrôle ou de mesure selon l'une des revendications précédentes,
**caractérisée par le fait que**
sur une pièce d'adaptation (4) portant une pointe de mesure on fait sortir latéralement un câble (27) relié à des éléments de raccordement à l'intérieur de la pièce d'adaptation et portant un autre départ de mesure à son extrémité libre.
